**Europäisches Patentamt**

**European Patent Office**

**Office européen des brevets**

(19)

(11) Veröffentlichungsnummer: **0 243 995**
**B1**

(12)

# EUROPÄISCHE PATENTSCHRIFT

(45) Veröffentlichungstag der Patentschrift:
03.10.90

(21) Anmeldenummer: 87200574.9

(22) Anmeldetag: 26.03.87

(51) Int. Cl.⁵: **B22F 1/00**, B22F 3/16,
C23C 14/34, H01J 37/34

(54) Verfahren zur Herstellung eines Targets für die Kathodenzerstäubung.

(30) Priorität: 30.04.86 AT 1162/86

(43) Veröffentlichungstag der Anmeldung:
04.11.87 Patentblatt 87/45

(45) Bekanntmachung des Hinweises auf die Patenterteilung:
03.10.90 Patentblatt 90/40

(84) Benannte Vertragsstaaten:
BE CH DE ES FR GB IT LI NL SE

(56) Entgegenhaltungen:
DE-A- 2 426 922
DE-A- 3 103 509
GB-A- 1 393 622

(73) Patentinhaber: **METALLWERK PLANSEE
GESELLSCHAFT M.B.H., A-6600 Reutte, Tirol(AT)**

(72) Erfinder: **Korb, Georg, Dr. Dipl.-Ing., Halbwegstrasse 11,
A-6600 Reutte/Mühl(AT)**

(74) Vertreter: **Lohnert, Wolfgang, Dr., Metallwerk Plansee
GmbH, A-6600 Reutte, Tirol(AT)**

## Beschreibung

Die Erfindung betrifft ein Verfahren zur Herstellung eines mehrkomponentigen, metallischen, nicht als einheitliche Legierung vorliegenden Targets für die Kathodenzerstäubung, insbesondere aus einem spröde Legierungen bildenden und/oder als Legierung spröde intermetallische Phasen aufweisenden Material, wobei mindestens eine Komponente kaltduktil ist.

Die Beschichtung mittels Kathodenzerstäubung hat in den vergangenen Jahren einen großen Aufschwung erlebt. Die Zerstäubungsverfahren wurden variantenreicher und in sich verfeinert. Die Verwendung derartiger Beschichtungstechniken reicht von der Herstellung verschleiß- und/oder korrosionsfester Oberflächenschichten bis zum schichtweisen Aufbau von Materialverbunden, insbesondere in der Elektronik. Entsprechend vielfältig sind die Ansprüche an Targets, und zwar sowohl hinsichtlich Materialzusammensetzung als auch hinsichtlich Form und Beschaffenheit.

Wurden als Targetmaterialien über lange Zeit nur einzelne Metalle und häufig verwendete Metallegierungen eingesetzt, so werden heute Targets gefordert, welche z. B. das gleichzeitige Abstäuben von mehreren, auch nicht legierungsfähigen Metallen oder von metallischen und nichtmetallischen Komponenten in engtolerierten Mischungsverhältnissen und hohen Reinheitsgraden erlauben. Zu den nicht legierungsfähigen Metallen bzw. Metall-Nichtmetall-Verbindungen sind unter anderem solche zu zählen, bei denen sich die einzelnen Komponenten in flüssiger Phase nicht miteinander mischen und/oder aufgrund ihrer großen Dichteunterschiede aus der Schmelze nicht homogen verfestigen lassen. Bei vielen heute als Targets gewünschten Legierungssystemen treten spröde intermetallische Phasen auf, so daß sich entsprechende Festkörper nicht mehr kalt oder warm umformen und häufig nicht mehr oder nur noch mit großem Aufwand spanabhebend bearbeiten lassen. Die vielfältigen Konstruktionen von heute gebräuchlichen Kathodenzerstäubungsanlagen erfordern aber jeweils bestimmte, oftmals komplexe geometrische Targetformen, welche in der Regel nur mittels spanabhebender Bearbeitung aus Rohlingen gefertigt werden können. Aus Leitfähigkeits- oder auch aus Stabilitätsgründen müssen Targets häufig auf Trägermaterialien aufgebracht, z. B. aufgeschraubt werden. Das erfordert zusätzliche Bohrungen im Target, welche in spröde Materialien einzubringen schwierig, mitunter unmöglich ist.

Gleichwohl ist im praktischen Beschichtungsbetrieb der Bruch von Targets eine sehr häufige Ausfallursache. Schon das Aufschrauben eines nur begrenzt duktilen Targets auf ein Trägermaterial führt mitunter bereits zum Bruch, weil für die Gewährleistung einer guten thermischen und elektrischen Leitfähigkeit durch die Kontaktfläche ein sehr inniger Verbund erzielt werden muß. Temperaturunterschiede zwischen Basiskathode und Target, aber auch unterschiedlich starkes Aufheizen des Targets infolge örtlich verschieden starken Ionenbeschusses führen zu mechanischen Spannungen im Target und sind häufige Bruchursachen.

Die Forderung nach hoher Dichtheit bzw. Porenfreiheit erschwert die Targetherstellung und schließt die Anwendung einer Vielzahl von metallurgischen und pulvermetallurgischen Verfahren von vornherein aus.

Die DE A1 24 26 922 gibt einen Überblick über die Vielzahl der Schwierigkeiten, die bei der "Herstellung von festen, homogenen Teilen aus konstitutionell komplexen Legierungen" auftreten können. Wie dort beschrieben, werden Teile, z. B. auch Targets, aus entsprechend komplexen Legierungen heute vielfach mittels Heißpressen von homogenen Pulvermischungen aus den einzelnen Legierungskomponenten erzeugt. Dabei werden die Komponenten unter allseitigem, insbesondere isostatischem Druck in der Regel unter Aufschmelzen der niedrigstschmelzenden Komponente kompaktiert und in einfache geometrische Targetformen gebracht. Bildet eine entsprechende Legierung spröde, intermetallische Phasen, so ist auch der heißgepreßte Formkörper spröde, daher mechanisch wenig belastbar und somit als Target für das Kathodenzerstäuben wenig geeignet. Vielfach läßt sich bei diesem Herstellungsverfahren auch nicht die gewünschte Porenfreiheit für das Targetmaterial erreichen.

Die DE A1 31 49 910 und ähnlich die DE C2 29 40 369 beschreiben einen anderen Weg zur Herstellung mehrkomponentiger Targets, welche sich nicht zu duktilen Legierungen verarbeiten lassen und doch gleichzeitig in einer Kathodenzerstäubungsanlage zerstäubt werden sollen. Dort werden in ein Grundtarget aus einem ersten Material Sacklöcher eingebracht und in diese das oder die anderen zu zerstäubenden Targetmaterialien als Stöpsel eingepreßt. Dieses Verfahren ist jedoch zum einen vergleichsweise teuer. Zum anderen können aufgrund der unterschiedlichen thermischen Ausdehnungen einzelner Komponenten die Stöpsel ihren festen Sitz und damit erforderliche thermische und elektrische Leitfähigkeit zum Basistarget verlieren. Außerdem ist bei der örtlichen Distanz der verschiedenen zu zerstäubenden Materialien und der in der Regel unterschiedlichen Abstäubraten von verschiedenen Oberflächenzonen eines Targets häufig die Zerstäubung verschiedener Komponenten in gleichbleibenden Konzentrations-Verhältnissen nicht gewährleistet.

Aufgabe der vorliegenden Erfindung ist danach ein Verfahren zur Herstellung von Targets aus zwei oder mehreren Metallen, ggf. um nichtmetallische Komponenten ergänzt, für welche die Herstellung durch Schmelzen oder mittels sintermetallurgischer Verfahren nicht oder nur eingeschränkt brauchbar ist. Das betrifft z. B. Komponenten, die legiert zu spröden Werkstoffen führen, welche sich anschließend weder ausreichend kalt oder warm umformen, noch für eine Target-Formgebung hinreichend spanabhebend bearbeiten lassen. Weiters sollen auch die oben beschriebenen Nachteile umgangen werden, welche für Targets genannt wurden, bei denen die einzelnen zu zerstäubenden Komponenten mechanisch aneinandergefügt werden, beispielsweise durch Einbringen von Stöpseln in ein Grundmaterial.

Die Aufgabe wird dadurch gelöst, daß das aus unlegierten Komponenten bestehende, ggf. duktile Sublegierungen enthaltende, pulverförmige Material zu einem Pulvergemenge gemischt, zu einem Formkörper kaltgepreßt und anschließend durch mehrmaliges Umformen, vorzugsweise in Schmiedepressen, bei Temperaturen unterhalb des Schmelzpunktes der niedrigstschmelzenden Komponente unter Fließen verdichtet und in Fortbestand des Materials als Pulvergemenge unter Kaltverschweißen in seinen kompakten Endzustand gebracht wird.

Die nach diesem Verfahren hergestellten Targets bilden einen homogenen Materialverbund, besitzen in der Regel 96 - 100 % ihrer theoretischen Dichte und weisen metallischen Charakter auf. Das schließt metallisches Aussehen, eine hohe mechanische Festigkeit sowie gute thermische und elektrische Leitfähigkeit ein. Dabei kommt es nicht zu einer echten Legierungsbildung oder zur Ausbildung intermetallischer Phasen. Lediglich an den Phasengrenzen kann es in einzelnen Fällen beim Umformen zu Ansätzen von Legierungsbildung kommen, ohne daß dadurch die mechanischen Eigenschaften des Verbundmaterials nennenswert beeinflußt werden.

Die mehrkomponentigen Targets besitzen die Duktilitätseigenschaften ihrer duktilen Einzelkomponenten. Das erfindungsgemäße Verfahren ist demnach auf Materialien beschränkt, bei denen zumindestens eine Hauptkomponente kaltduktil ist.

Das erfinderische Verfahren hat sich insbesondere zur Herstellung von Targets für die Kathodenzerstäubung aus Aluminium mit Blei, Titan und/oder Tantal als zweite metallische Komponente bewährt. Infolge der hohen Duktilität des Aluminiums lassen sich in diesen Fällen bereits durch das Kaltpressen vor dem Umformen ca. 90 % der theoretischen Dichte erreichen.

Im Unterschied etwa zum Heißpressen lassen sich nach dem erfinderischen Verfahren die genannten Vorteile für Targets dadurch erzielen, daß die Komponenten des Targetmaterials nicht nur verdichtet, sondern unter Fließen derselben umgeformt werden, ohne jedoch zu erschmelzen und damit zu legieren. Dabei haben sich neben hydraulischem Schmiedepressen auch andere Pressen, z. B. Friktionspressen, mit offenen, halboffenen oder geschlossenen Gesenken in etwa gleichermaßen bewährt.

Das Umformen durch Schmieden erfolgt selten in einer, vorzugsweise jedoch in 3 - 8 Stufen, wobei eine Gesamtverformung von mindestens 30 %, vorzugsweise jedoch 50 - 70 % aufgebracht wird.

Derartig umgeformte, mehrkomponentige metallische Targets lassen sich aufgrund ihrer unverändert hohen Duktilität ohne Schwierigkeiten mechanisch bearbeiten, sei es beispielsweise durch Flachwalzen oder durch spanabhebende Bearbeitung zur Herstellung der gewünschten Targetform. Auf diese Weise lassen sich nicht nur beliebig geformte Targets für den Einsatz in Zerstäubungsanlagen mit günstigeren mechanischen Eigenschaften herstellen. Das erfinderische Verfahren ermöglicht zudem die Herstellung von Targets aus entsprechenden Materialien in weit größeren Abmessungen als bisher.

Die Erfindung wird nachfolgend anhand eines Ausführungsbeispieles näher erläutert.

Zur Herstellung eines Aluminium/Titan-Targets für die Kathodenzerstäubung Atomverhältnis 1 : 1, werden Pulver der beiden Metallkomponenten mit 20 - 120 µm durchschnittlicher Teilchengröße in einem Taumel- oder Zwangsmischer vermischt und in einer geeigneten Preßmatrize mittels einer hydraulischen Presse zu Grünlingen kaltverpreßt. Aufgrund der hohen Duktilität des Aluminiums besitzt der Grünling bereits ca. 94 % seiner theoretischen Dichte und für die Handhabung bei der weiteren Verarbeitung asreichende mechanische Festigkeit. Der so gefertigte Rohling wird in einer Schmiedepresse mit halboffenem Gesenk unter Fließen bzw. Verkneten der einzelnen Komponenten bei 150 - 200°C Gesenktemperatur in insgesamt fünf Durchgängen nachverdichtet. Das Targetmaterial wird vor dem Nachverdichten und zwischen den einzelnen Verdichtungsschritten in einem Wärmeofen auf einer Temperatur von 250 - 400°C ansteigend gehalten. Das Nachverdichten des Al-Ti-Targetmaterials erfolgt im nicht gekannten Zustand, d. h. die kurzen Umformzeiten und relativ niedrigen Umformtemperaturen machen einen Oxidationsschutz überflüssig.

Nach dem mechanischen Verdichten wurden die Targets durch mechanisches Bearbeiten in eine runde oder rechteckige Form mit einem äußeren Durchmesser von ca. 150 mm bzw. von ca. 100 × 500 mm² Rechtecksform und 6 mm Dicke gebracht.

Das so hergestellte Target für Kathodenzerstäubung wurde in einer industriellen Magnetron-Sputteranlage eingesetzt und dort mit hohen Raten zerstäubt, ohne daß dabei einer der anfangs aufgeführten Nachteile bekannter Targets gleicher Materialkomposition auftraten.

Vergleichende Untersuchungen des derart hergestellten Targets mit einem Target gleichen Materialaufbaues, jedoch hergestellt nach der Technik des Heißpressens zeigten die Überlegenheit des erfindungsgemäßen Verfahrens in Gestalt einer sprunghaften Steigerung der Dichtheit und mechanischer Festigkeit des Targetmaterials.

**Patentansprüche**

1. Verfahren zur Herstellung eines mehrkomponentigen, metallischen, nicht als einheitliche Legierung vorliegenden Targets für die Kathodenzerstäubung, insbesondere aus einem spröde Legierungen bildenden und/oder als Legierung spröde intermetallische Phase aufweisenden Material, wobei mindestens eine Komponente kaltduktil ist, **dadurch gekennzeichnet,** daß das aus unlegierten Komponenten bestehende, ggf. duktile Sublegierungen enthaltende, pulverförmige Material zu einem Pulvergemenge gemischt, zu einem Formkörper kaltgepreßt und anschließend durch mehrmaliges Umformen, vorzugsweise in Schmiedepressen, bei Temperaturen unterhalb des Schmelzpunktes der niedrigstschmelzenden Komponente unter Fließen verdichtet und in Fortbestand des Materials als Pulvergemenge unter Kaltverschweißen in seinen kompakten Endzustand gebracht wird, wodurch Targets mit etwa 96 - 100 % theoretischer Dichte und metallischem Charakter erhalten werden.

2. Verfahren zur Herstellung eines Targets nach Anspruch 1, dadurch gekennzeichnet, daß das Material vor dem Umformen in eine Schutzhülle eingekannt wird.

3. Verfahren zur Herstellung eines Targets nach den Ansprüchen 1 und 2, dadurch gekennzeichnet, daß das eingesetzte Material aus Al sowie Pb, Ti und/oder Ta besteht.

**Claims**

1. Method for producing a multiconstituent, metallic target, which is not a homogeneous alloy, for cathode sputtering, in particular of a material forming brittle alloys and/or comprising a brittle intermetallic phase as an alloy, at least one constituent being ductile when cold, characterised in that the powdery material, which consists of unalloyed constituents and may contain ductile suballoys, is made into a powder mixture, cold-pressed into a blank, then compressed in a fluid state by repeated forming, preferably in forging presses, at temperatures below the melting point of the constituent with the lowest melting point and, with the material still in the form of a powder mixture, brought into its final compact state during cold-welding, so as to obtain targets with a theoretical density of approximately 96–100 and a metallic nature.

2. Method for producing a target according to claim 1, characterised in that the material is enclosed in a protective sheath before being formed.

3. Method for producing a target according to claims 1 and 2, characterised in that the material used consists of Al as well as Pb, Ti and/or Ta.

**Revendications**

1. Procédé de fabrication d'une cible métallique à plusieurs composants, qui n'existe pas en tant qu'alliage homogène, pour la pulvérisation cathodique, en particulier en un matériau constituant des alliages fragiles et/ou présentant comme alliage une phase intermétallique fragile, au moins un composant étant ductile à froid, caractérisé en ce que le matériau pulvérulent, constitué des composants non alliés, contenant éventuellement des sous-alliages ductiles, est mélangé en un mélange pulvérulent, comprimé à froid en un corps de forme, et ensuite, densifié par fluage, par déformations multiples, de préférence en compression par forgeage, à des températures inférieures au point de fusion des composants à point de fusion le plus bas, et que, dans cet état du matériau sous forme de mélange pulvérulent, il est transformé par soudage à froid dans son état final compact, grâce à quoi il est possible de réaliser des cibles d'une densité d'environ 96 à 100% de la densité théorique et d'un caractère métallique.

2. Procédé de fabrication d'une cible selon la revendication 1, caractérisé en ce que le matériau avant le formage est introduit dans une douille de protection.

3. Procédé de fabrication d'une cible selon les revendications 1 et 2, caractérisé en ce que le matériau utilisé se compose d'Al ainsi que de Pb, de Ti et/ou de Ta.